# EUROPEAN PATENT SPECIFICATION

(11) **EP 0 905 751 B1**
(45) Date of publication and mention of the grant of the patent: **13.12.2006**
(21) Application number: 98307025.1
(22) Date of filing: 01.09.1998
(51) Int. Cl.: H01L 21/28, H01L 21/8238

(54) **Method for minimizing lateral and vertical dopant diffusion in gate structures**
Verfahren zum Minimieren von vertikaler und lateraler Dotierstoffdiffusion in Gatterstrukturen
Méthode pour minimiser les diffusions latérales et verticales de dopants dans les structures de porte

(30) Priority: 29.09.1997 US 939209
(43) Date of publication of application: 31.03.1999
(73) Proprietor: Qimonda AG, 81739 München (DE); International Business Machines Corporation, Armonk, N.Y. 10504 (US)
(72) Inventor: Loh, Stephen K., Fishkill, NY 12524 (US); Parks, Christopher C., Beacon, NY 12503 (US); Dehm, Christine, Wappingers Falls, NY 12590 (US)
(74) Representative: Nash, David Allan

(56) References cited:
- EP-A- 0 682 359
- EP-A- 0 780 889
- EP-A- 0 903 776
- US-A- 4 935 804
- "PROCESS FOR SUPPRESSION OF ANOMALOUS SUB-THRESHOLD LEAKAGE" IBM TECHNICAL DISCLOSURE BULLETIN, vol. 37, no. 11, 1 November 1994, page 177 XP000487204
- HOSOYA T ET AL: "A POLYCIDE GATE ELECTRODE WITH A CONDUCTIVE DIFFUSION BARRIER FORMED WITH ECR NITROGEN PLASMA FOR DUAL GATE CMOS" IEEE TRANSACTIONS ON ELECTRON DEVICES, vol. 42, no. 12, 1 December 1995, pages 2111-2116, XP000582420
- KAZUHIRO KOBUSHI ET AL: "A HIGH INTEGRITY AND LOW RESISTANCE TI-POLYCIDE GATE USING A NITROGEN ION-IMPLANTED BUFFER LAYER" JAPANESE JOURNAL OF APPLIED PHYSICS, vol. 27, no. 11, 1 November 1988, pages 2158-2160, XP000068677

## Description

### BACKGROUND OF THE INVENTION

### 1. Field of Invention

The invention relates generally to methods and apparatus for fabricating gates for integrated circuits. More particularly, the invention relates to a method for reducing the amount of dopant outdiffusion in a gate structure during processing of the gate structure.

### 2. Description of the Relevant Art

As the demand for integrated circuits, such as dynamic random access memory (DRAM) integrated circuits, increases, the need for efficiently produced integrated circuits is also increasing. Producing integrated circuits in such a way that the integrity of the integrated process may be protected throughout the fabrication process increases the overall throughput of the integrated circuits.

When a gate structure, *e.g.,* a gate level interconnect, is formed, dopants in the silicon layers of a gate structure are likely to vertically diffuse into a silicide layer of the gate structure during annealing processes which generally occur at temperatures of greater than approximately 800 degrees Centigrade. Annealing processes may be used to "drive" dopants to create a source or a drain using the gate structure, as will be appreciated by those skilled in the art.

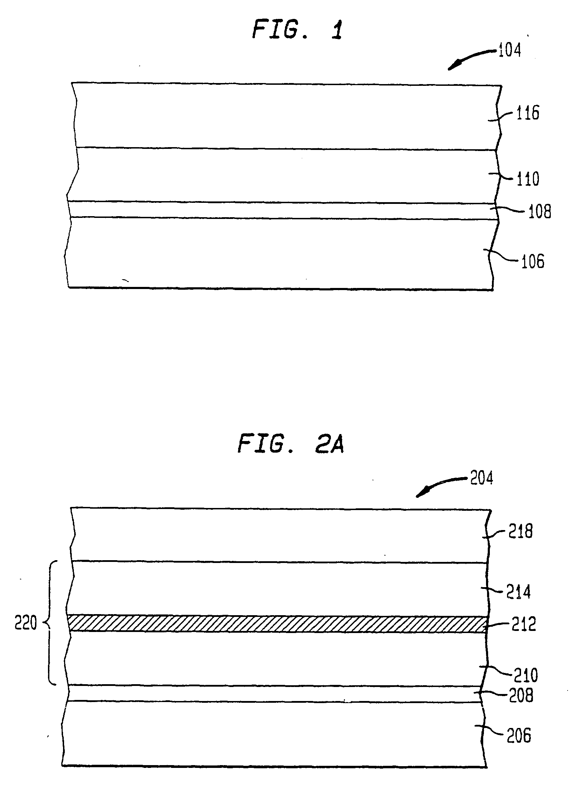

Figure 1 is a diagrammatic representation of the layers included in a conventional gate structure in an integrated circuit. A gate structure 104 is typically included as part of an integrated circuit, *e.g.,* a DRAM integrated circuit. Gate structure 104 includes a substrate 106. Substrate 106 is generally formed from silicon, and may also include various other layers associated with the formation of the integrated circuit of which gate structure 104 is a part. By way of example, substrate 106 may include various insulating layers and conducting layers.

A gate oxide layer 108 overlays substrate 106, and a doped silicon layer 110 is formed over gate oxide layer 108. Doped silicon layer 110, which is typically a polycrystalline silicon layer, is doped using a dopant such as boron, phosphorous, or arsenic. A silicide layer 116 is arranged over doped silicon layer 110. In general, silicide layer 116 is relatively low in resistance, and is often formed from a silicide such as titanium silicide or tungsten silicide.

Dopant that is present in doped silicon layer 110 has a tendency to vertically diffuse, or migrate, into silicide layer 116 during annealing processes, *e.g*., processes at temperatures of greater than approximately 300 degrees Centigrade. It has been observed that the amount of dopant which diffuses into silicide layer 110 during annealing processes is greater than approximately 50 percent, as for example in the range of approximately 50 percent to approximately 70 percent, of the total amount of dopant in doped silicon layer 110.

When dopant diffuses into silicide layer 116, given that silicide layer is relatively low in resistance, dopant which reaches silicide layer 116 readily laterally diffuses through silicide layer 116. Since silicide layer 116 generally overlays adjacent, distinct, doped regions, as for example in a dual workfunction gate, which are doped with different dopants, lateral diffusion of dopant through silicide layer 116 may contaminate different regions. Similarly, lateral diffusion of dopant within silicon layer 110 may also contaminate differently doped regions. Contamination of doped regions generally detrimentally affects the performance of the device which includes the doped regions. Hence, annealing is often limited to reduce the amount of dopant which diffuses within silicon layer 110 in both the lateral direction and the vertical direction, which diffuses into silicide layer 116. That is, the thermal budget of integrated circuit fabrication processes may be limited in order to reduce contamination.

Reducing the thermal budget of an integrated circuit fabrication process, while generally effective in reducing contamination of doped regions, often proves to be undesirable. For example, when the thermal budget is reduced, high temperature steps, *i.e.,* steps which occur at temperatures of greater than approximately 900 degrees Centigrade, in an overall integrated circuit may be shortened. Such steps are used to heal dislocations, reflow dielectrics, and to active doped junctions, for example. Further, for DRAMS, reducing the number of dislocations which may be healed generally significantly compromises the retention time associated with the DRAM by increasing device leakage. Retention time is the time a DRAM cell retains its stored charge, and is limited by the rate at which the stored charge leaks away.

Therefore, what is desired is a method for reducing dopant outdiffusion in a gate structure without compromising the integrity of the performance of an integrated circuit which includes the gate structure.

The document EP-A-0682359 describes the formation of a nitrogen containing barrier using a nitrogen plasma.

The document EP-A-0903776, which falls under Article 54(3) EPC, describes the formation of a nitrogen containing barrier by first oxidizing the polysilicon, then nitridizing the oxide followed by removing the nitridized oxide.

### SUMMARY OF THE INVENTION

According to one aspect of the present invention, there is provided a method for minimising dopant outdiffusion within an integrated circuit, the method comprising: forming a substrate; forming a gate oxide layer at least partially over the substrate; depositing a first doped silicon layer over the gate oxide layer; forming a first oxide layer over the first silicon layer; nitridizing the first oxide layer, wherein nitridizing of the first oxide layer causes nitride to form on at least the surface of the first silicon layer at the grain boundaries forming a barrier layer to prevent dopant diffusion; etching the nitridized first oxide layer wherein etching the nitridized first oxide layer exposes the nitride at grain boundaries of the first silicon layer; depositing a second silicon layer over the nitride exposed at the grain boundaries of the first silicon layer; forming a second oxide layer over the second silicon layer; nitridizing the second oxide layer, wherein nitridizing of the second oxide layer causes nitride to form on at least the surface of the second silicon layer at the grain boundaries forming a barrier layer to prevent dopant diffusion; etching the nitridized second oxide layer, wherein etching the nitridized second oxide layer exposes the nitride at a grain boundaries of the second silicon layer; and forming a silicide layer over the second silicon layer.

### BRIEF DESCRIPTION OF THE DRAWINGS

The invention, together with further advantages thereof may best be understood by reference to the following description taken in conjunction with the accompanying drawings in which:
Figure 1 is a diagrammatic representation of the layers of a conventional gate structure in an integrated circuit.
Figure 2a is a diagrammatic representation of the layers of a first gate structure in an integrated circuit with a barrier layer.
Figure 2a is not part of the invention.

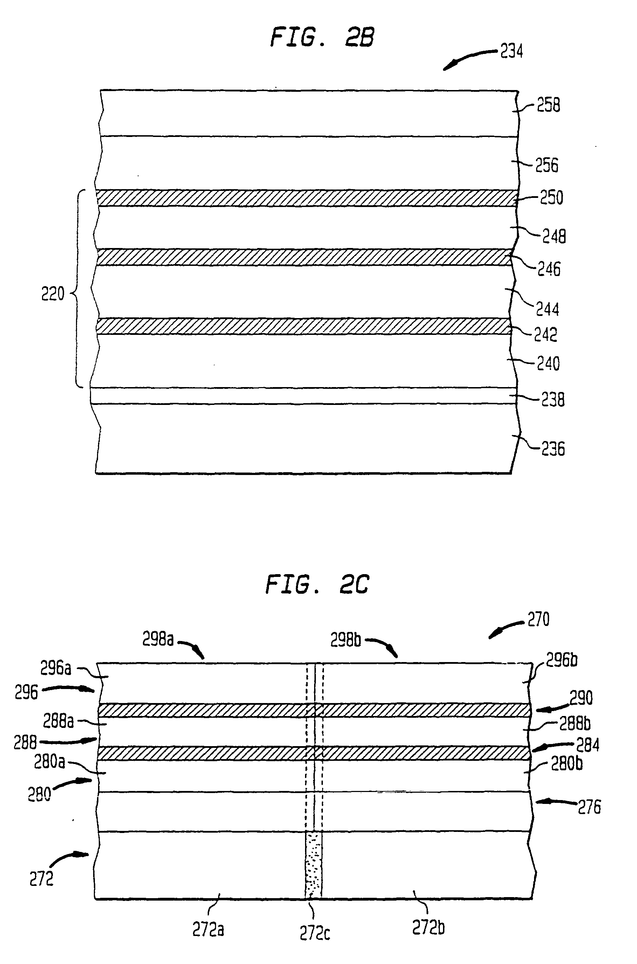

Figure 2b is a diagrammatic representation of the layers of a second gate structure in an integrated circuit with multiple barrier layers in accordance with the present invention.
Figure 2c is a diagrammatic representation of a portion of a dual workfunction gate in accordance with the present invention.

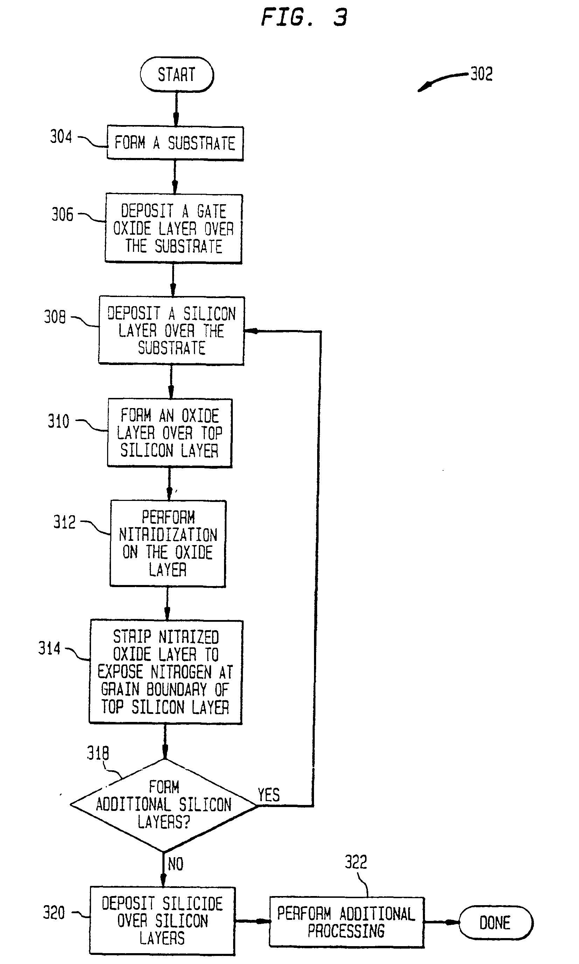

Figure 3 is a process flow diagram which illustrates the steps associated with one method of fabricating a gate structure in an integrated circuit, with a barrier layer.
Figure 3 is not part of the invention.

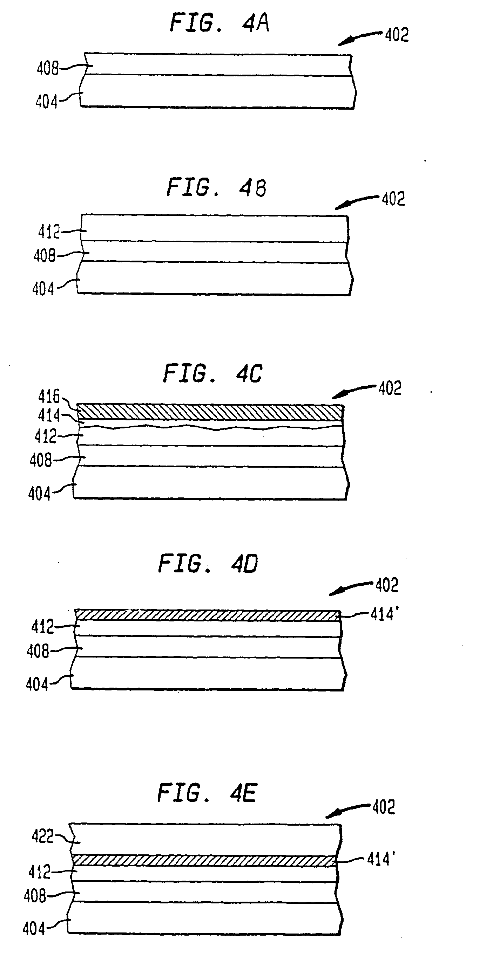

Figure 4a to 4e are not part of the invention.
Figure 4a is a diagrammatic representation of a gate structure prior to the formation of a first silicon layer.
Figure 4b is a diagrammatic representation of the gate structure of Figure 4a after the formation of a first silicon layer.
Figure 4c is a diagrammatic representation of the gate structure of Figure 4b after an oxide layer has been deposited over the first silicon layer.
Figure 4d is a diagrammatic representation of the gate structure of Figure 4c after the oxide layer has been nitridized and etched.
Figure 4e is a diagrammatic representation of the gate structure of Figure 4d after a silicide layer has been deposited over the first silicon layer.

### DETAILED DESCRIPTION OF THE EMBODIMENTS

The following as not part of the invention and is given for illustration purpose only. In the following description, numerous specific details are set forth in order to provide a thorough understanding of the present invention. Well known structures and steps have not been described in detail in order not to unnecessarily obscure the present description.

In order to reduce the amount of dopant outdiffusion into a silicide layer of a gate structure, *e.g.*, a gate interconnect structure, during annealing processes, a barrier to diffusion is formed in accordance with one aspect of the present invention within the gate structure to impede the diffusion of dopants. Figure 2a is a diagrammatic representation of the layers a first gate structure in an integrated circuit with a barrier layer. It should be appreciated that for illustrative purposes, some features of the gate structure have been exaggerated, while others have not been shown.

As shown, a gate structure 204 may be included as part of an integrated circuit. Such integrated circuit is, for example, a random access memory (RAM), a dynamic random access memory (DRAM), a synchronous DRAM (SDRAM), and a read only memory (ROM). Other integrated circuit such as an application specific integrated circuit (ASIC), a merged DRAM-logic circuit (embedded DRAM), or any other logic circuit is also useful.

Typically, numerous integrated circuits are formed on the wafer in parallel. After processing is finished, the wafer is diced to separate the integrated circuits to individual chips. The chips are then packaged, resulting in a final product that is used in, for example, consumer products such as computer systems, cellular phones, personal digital assistants (PDAs), and other electronic products.

The gate structure is formed on a substrate 206, such as silicon wafer. Other substrates such as gallium arsenide, germanium, silicon on insulator (SOI), or other semiconductor materials are also useful. The substrate, for example, may be lightly or heavily doped with dopants of a pre-determined conductivity to achieve the desired electrical characteristics. Substrate 206 may also include various other layers associated with the formation of gate structure 204 or, more generally, the integrated circuit of which gate structure 204 is a part. By way of example, substrate 206 may include insulating layers, conducting layers, and various junction regions, as will be appreciated by those skilled in the art.

A gate oxide layer 208 overlays substrate 206. Gate oxide layer 208 may generally be formed from any suitable material, as for example thermally grown oxide or nitrided oxides. A silicon layer 210 is formed over gate oxide layer 208. Silicon layer 210, which may be a polycrystalline silicon layer, *e.g,* "polysilicon" layer, is doped using a dopant such as boron, phosphorous, or arsenic. A barrier layer 212 lies over silicon layer 210 and is nitride which is located at the grain boundaries of silicon layer 210, *e.g,* within silicon layer 210 and especially near the top surface of silicon layer 210.

Barrier layer 212 serves to reduce the amount of dopant that vertically and laterally outdiffuses from silicon layer 210 during annealing processes associated with creating a source or a drain using gate structure 204. It should be appreciated that barrier layer 212 controls dopant diffusion during annealing while maintaining a low contact resistance. Barrier layer 212 generally maintains its integrity during the annealing at high temperature processing, *e.g.,* processing at temperatures of greater than approximately 900 degrees Centigrade.

A silicide layer 216 is arranged over barrier layer 212. In general, silicide layer 216 is low in resistance and, in one embodiment, silicide layer 216 may be formed from titanium silicide (TiSiₓ). Other silicides, such as tungsten silicide (WSiₓ), molybdenum silicide (MoSiₓ), tantalum silicide (TaSiₓ), cobalt silicide (CoSiₓ), or any other silicides, are also useful.

Barrier layer 212 reduces the amount of dopant which vertically diffuses from silicon layer 210 into silicide layer 216. Silicon layers 210, 214, together with barrier layer 212, form a layered silicon structure 220. In general, layered silicon structure 220 may include substantially any number of silicon layers and barrier layers. A gate structure with a silicon structure which includes multiple silicon layers and barrier layers will be described in more detail below with respect to Figure 2b.

As shown, gate structure 204 may also include a dielectric layer 218 which is formed over silicide layer 216. In general, dielectric layer 218 may be used to insulate different layers of gate structure 204 from other layers of the integrated circuit which includes gate structure 204. The dielectric layer may also serve as an etch stop layer for subsequent processing, such as to form a borderless contact.

The dimensions, *e.g.,* thickness, of layers in gate structure 204 may generally be widely varied. The thickness of each layer within gate structure 204 may depend upon the application in which gate structure 204 is to be used. For example, the thicknesses of the layers may be smaller for 0.175 micron DRAM generation than for 0.25 micron DRAM generation. The gate oxide layer 208 may have a thickness in the range of approximately 30 Angstroms to approximately 100 Angstroms, *e.g.,* approximately 60 Angstroms to approximately 65 Angstroms. In such a case, the layered silicon structure may have a thickness in the range of approximately 1000 Angstroms to approximately 2000 Angstroms, while silicide layer 216 may have a thickness in the range of approximately 50nm (500 Angströms) to approximately 200nm (2000 Angströms).

Referring next to Figure 2b, the composition of a second gate structure with multiple barrier layers will be described in accordance with an embodiment of the present invention. A gate structure 234, like gate structure 204 of Figure 2a, may be included as part of an integrated circuit, *e.g.,* a DRAM. Gate structure 234 includes a substrate 206. A gate oxide layer 208 overlays substrate 206. In the described embodiment, a multi-layered silicon structure 270 is formed over gate oxide layer 208.

Multi-layered silicon structure includes multiple silicon layers 240, 244, 248, as well as multiple barrier layers 242, 246, 250. Each silicon layer 240, 244, 248 may be formed from any suitable silicon, as for example polycrystalline silicon. In general, silicon layer 240, which substantially directly overlays gate oxide layer 238, is doped using a dopant such as boron, phosphorous, or arsenic. Each silicon layer 244, 248 may either be doped or undoped. If any of silicon layers 244, 248 are doped, in the described embodiment, silicon layers 244, 248 are doped differently than silicon layer 240, *e.g.*, doped using different dopants. It should be appreciated, however, that in other embodiments, substantially all silicon layers 240, 244, 248 may be doped using substantially the same dopants.

Barrier layers 242, 246 generally lie between silicon layers 240, 244, 248. Specifically, as shown, barrier layer 242 lies between silicon layers 240, 244, barrier layer 246 lies between silicon layers 244, 248. A barrier layer, *e.g.,* barrier layer 242 which lies over silicon layer 240, is a film of nitride which is located at the grain boundaries near the top of silicon layer 240. The barrier layer 242 is formed using a nitridizing process, as will be discussed in more detail below with reference to Figure 3.

Barrier layer 242 is arranged to reduce the amount of dopant that vertically outdiffuses from silicon layer 240 during annealing processes. The use of multiple barrier layers 242, 246, 250 essentially creates a matrix of barrier layers in or on layered silicon structure 270 to better control the overall amount of dopant which is essentially diffused out of silicon structure 270. In other words, by providing multiple barrier layers 242, 246, 250 within silicon structure 270, the vertical and lateral diffusion of dopants within gate structure 234 may be more readily controlled.

A silicide layer 256, which may be formed from silicides which include, but are not limited to, titanium silicide and tungsten silicide. Barrier layers 242, 246, 250 within silicon structure 270, as mentioned above, reduce the amount of dopant which diffuses from silicon layer 240 into silicide layer 256. In one embodiment,, gate structure 234 may include a dielectric layer 258 which is formed over silicide layer 256. Dielectric layer 258 may generally be used to insulate different layers of gate structure 234 from other layers of an integrated circuit which includes gate structure 234.

Gate structures which use of barrier layers to control dopant outdiffusion may be used in a variety of different applications. As barrier layers may reduce both vertical diffusion to a silicide layer and lateral diffusion through the silicide layer, the use of gate structures with barrier layers is particularly useful in dual workfunction gates. Figure 2c is a diagrammatic representation of a portion of a dual workfunction gate in accordance with an embodiment of the present invention. For ease of illustration, some features of the dual workfunction gate have been exaggerated, while others have not been shown.

A dual workfunction gate 270 includes a junction region 272 which may be a part of a semiconductor wafer substrate (not shown). Junction region 272 includes doped regions 272a, 272b. The doped region 272a comprises dopant of a first conductivity and the doped region 272b comprises dopant of a second conductivity. In the described embodiment, region 272a may be "p-doped," while region 272b may be "n-doped." An undoped region 272c is located between regions 272a, 272b essentially to prevent dopants in region 272a from mixing with dopants in region 272b.

As shown, a gate oxide layer 276 is formed directly over junction region 272. A first doped silicon layer 280 is located over gate oxide layer 276. In general, doped regions 280a, 280b, may be doped differently from one another. Region 280a which indirectly overlays region 272a may be doped in the same manner as region 272a, *e.g.,* both region 272a and region 280a may be p-doped, while region 280b and region 272b, which region 280b indirectly overlays, may both be n-doped.

A first barrier film 284 overlays doped silicon layer 280. The barrier layer comprises a material which is of sufficient thickness to prevent dopants in doped silicon layer 280 from laterally and vertically diffusing. In other words, first barrier film 284 obstructs the vertical and lateral diffusion of dopants therethrough during annealing processes. The barrier comprises nitride at grain boundaries of doped silicon layer 280.

A second silicon layer 288, which may or may not be doped, overlays first barrier film 284. A second barrier film 290 overlays second silicon layer 288 to further control vertical diffusion of dopants. Silicon layers 280, 288, together with barrier films 284, 290, form a layered silicon structure, as described above.

A silicide layer 296 overlies silicon layer 292. Dopant diffusion into silicide layer 296 is generally reduced through the use of barrier films 284, 290. Lateral diffusion of dopants within silicide layer 296 may readily occur if dopants are allowed to vertically diffuse into silicide layer 296. However, with the inclusion of barrier films 284, 290, the amount of dopant which vertically diffuses into silicide layer 296 and, hence, the amount of dopant which laterally diffuses through silicide layer 296 may be reduced. As a result, distinct regions 298a, 298b may be maintained in dual workfunction gate 270.

In gate structures without barrier layers, the amount of dopant which diffuses, or migrates, into a silicide layer during annealing processes at temperatures of greater than approximately 800 degrees Centigrade has been observed as being greater than approximately 50 percent, as for example in the range of approximately 50 percent to approximately 70 percent, of the total amount of dopant in a doped silicon layer. With the use of barrier layers, the amount of dopant which diffuses into a silicide layer has been observed as being less than approximately 20 percent, *e.g.,* in the range of approximately 4 percent to approximately 15 percent, of the total amount of dopant in a doped silicon layers.

The following is not part of the invention and is given for illustration purpose only.

Figure 3 is a process flow diagram which illustrates the steps associated with the process used to fabricate a gate structure, *e.g.,* gate structure 204 of Figure 2a, which includes a barrier layer, in an integrated circuit. The process 302 begins at step 304 where a substrate, *e.g,* a semiconductor wafer substrate, is provided. The substrate may generally be formed from silicon, and may further include various layers associated with the overall formation of an integrated circuit. Such layers may include, but are not limited to, metallization layers and oxide layers.

A gate oxide layer is deposited over the substrate in step 306. Once the gate oxide layer is deposited, then process flow moves to step 308 where a silicon layer is deposited over the substrate or, more particularly, the gate oxide layer. In general as mentioned above, the silicon layer may be formed from any suitable silicon, as for example a polycrystalline silicon. The silicon layer, which is doped, may be doped using any suitable method, such as in situ doping or implantation of a dopant followed by an annealing process, as will be appreciated by those skilled in the art. While dopants used to dope the silicon layer may be widely varied, in one embodiment, dopants include phosphorous, boron, and arsenic.

An oxide layer is then formed on the polysilicon layer in Step 310. The oxide layer, which may be a silicon dioxide (SiO₂) layer, may be grown on the surface of the silicon layer using any suitable method. Typically, the oxide layer may be grown using a rapid thermal oxidation (RTO) in oxygen at a temperature in the range of approximately 900 degrees Centigrade to approximately 1100 degrees Centigrade, as for example approximately 925 degrees Centigrade, for a time duration in the range of approximately 30 seconds to approximately 120 seconds, as for example approximately 60 seconds. While the thickness of the oxide layer may be widely varied the thickness of the oxide layer is in the range of approximately 4 nm (40 Angströms) to approximately 5nm (50 Angströms).

Once the oxide layer is grown in step 310, process flow proceeds to step 312 in which a nitridization process is performed on the oxide layer. In other words, the oxide is nitridized. Oxide may generally be nitridized using any suitable method, such as a rapid thermal nitridization (RTN) using ammonia (NH₃), or other suitable nitrogen-contained gases, at a temperature in the range of approximately 900 degrees Centigrade to approximately 1100 degrees Centigrade, *e.g.,* approximately 1050 degrees Centigrade, for a duration in the range of approximately 20 seconds to 120 seconds, *e.g.,* approximately 30 seconds.

When the oxide layer is nitridized, nitride, *e.g.*, silicon nitride (SiNₓ), forms on the surface of the silicon layer and at the grain boundaries of the silicon layer. That is, an SiNₓ film forms at the interface between the oxide layer and at the grain boundaries the underlying silicon layer. In general, nitride diffuses along the grain boundaries of the silicon layer. When the thickness of the silicon layer is relatively thin, nitride may permeate substantially the entire silicon layer when the oxide layer is nitridized. When nitride permeates substantially the entire silicon layer, both vertical dopant diffusion and lateral dopant diffusion may be significantly reduced, as for example in a dual workfunction gate, as described above with respect to Figure 2c.

After the nitridization on the oxide layer is completed, the nitridized oxide layer is stripped, or otherwise etched, to expose nitrogen at the grain boundaries of the silicon layer in step 314. The exposed nitrogen at the grain boundaries forms a barrier layer which prevents dopant diffusion in a vertical direction between the underlying silicon layer and layers which overlay the silicon layer. It should be appreciated that the barrier layer may also reduce the amount of dopant diffusion in a lateral direction.

A determination is made in step 318 regarding whether additional silicon layers are to be formed over the new silicon layer. If the determination is that additional silicon layers are to be formed, the indication is that a thicker, "overall" silicon layer is desired within the gate structure. In general, the overall silicon layer is a layered structure, as the overall silicon layer includes at least two individual silicon layers with a barrier layer formed therebetween. A thicker overall silicon layer may be used to provide a plurality of barrier layers in a gate structure to further reduce the amount of both vertical and lateral diffusion within the gate structure. A silicon layer which includes an individual silicon layer with a barrier film over it may be used to reduce both vertical and lateral diffusion.

If the determination in step 318 is that at least one additional silicon layer is to be formed over the existing silicon layers, then process flow returns to step 308 where a new silicon layer is formed over the substrate or, more specifically, over the barrier layer. Alternatively, when the determination is that no additional silicon layers are to be formed, then process flow moves to step 320 in which a silicide layer is deposited over the silicon layers. Then, in step 322, additional processing is performed to complete the processing of the gate structure. In general, the additional processing may include, but is not limited to, depositing an insulating layer, *e.g.,* a dielectric layer, over the silicide layer, lithographic patterning dry etching sidewall spacer formation, and junction doping. Once the additional processing is completed, then the process of fabricating a gate structure is completed.

Referring next to Figures 4a-4e, the fabrication of a gate structure, using the steps described above with respect to Figure 3, will be described. It should be appreciated that for illustrative purposes, some features of the gate structure, particularly the size of a barrier layer, have been exaggerated, while others have not been shown. The fabrication of a gate structure 402 begins with the formation of a substrate 404. A gate oxide layer 408 is formed over the substrate

A doped silicon layer 412 is formed over gate oxide layer 408. An oxide layer 416 is deposited over the doped silicon layer 412 to promote the formation of a barrier layer. During a nitridization of the oxide layer 416, as described above with respect to Figure 3, nitride is essentially implanted at the grain boundaries 414 of doped silicon layer 412. After the oxide layer 416 is striped away, a barrier layer 414', which may be a film, that is formed at the grain boundaries 414 of doped silicon layer 412, is exposed. A silicide layer 422 is deposited over barrier layer 414'. In general, various other layers may be associated with gate structure 402, including a dielectric layer (not shown) which is often deposited over silicide layer 422.

A gate structure which includes a barrier layer has been described as being suitable for use in the fabrication of a dual workfunction gate that may be include in an integrated circuit such as a dynamic random access memory (DRAM). In general, however, the gate structure which includes a barrier layer may be suitable for use in a variety of other applications.

As previously mentioned, the silicon layers in a gate interconnect structure, such as a gate interconnect structure in a dual workfunction gate, may be formed from any suitable silicon. For example, the silicon layers may be polycrystalline silicon layers.

In general, a layered silicon structure may include any number of different silicon layers. The number of silicon layers in the silicon structure is generally dependent upon the overall desired thickness of the silicon structure, as well as the thickness of the individual layers and the barrier layers. As described above, the overall thickness of the silicon structure may be widely varied. By way of example, the thickness may be in the range of approximately 1000 Angstroms to approximately 2000 Angstroms. Similarly, the thicknesses of the silicon layers and the barrier layers may also be widely varied. The thickness of each silicon layer may be in the range of approximately 10nm (100 Angströms) to approximately 50nm (500 Angströms) while the thickness of each barrier layer may be in the range of approximately 5 nm (50 Angströms) to approximately 8 nm (80 Angströms).

While the silicon layer which substantially directly overlays a gate oxide layer is generally doped, subsequent silicon layers are not necessarily doped. When some of the subsequent silicon layers are doped, those silicon layers are often doped differently from the silicon layer which substantially contacts the gate oxide layer.

Further, the top-most barrier layer of a layered silicon structure has been described as being the top layer of the silicon structure, *i.e.*, the layer over which silicide is typically directly deposited. However, it should be appreciated that the top-most barrier layer may also be "sandwiched" between silicon layers.

## Claims

1. A method for minimising dopant outdiffusion within an integrated circuit, the method comprising:
forming a substrate (236,272);
forming a gate oxide layer (238,276) at least partially over the substrate (236, 272);
depositing a first doped silicon layer (240, 280) over the gate oxide layer (238, 276);
forming a first oxide layer over the first silicon layer (240, 280);
nitridizing the first oxide layer , wherein nitridizing of the first oxide layer causes nitride to form on at least the surface of the first silicon layer (240,280) at the grain boundaries forming a barrier layer to prevent dopant diffusion;
etching the nitridized first oxide layer, wherein etching the nitridized first oxide layer exposes the nitride at grain boundaries of the first silicon layer (240, 280);
depositing a second silicon layer (244, 288) over the nitride exposed at the grain boundaries of the first silicon layer (240, 280);
forming a second oxide layer over the second silicon layer (244, 288);
nitridizing the second oxide layer, wherein nitridizing of the second oxide layer causes nitride to form on at least the surface of the second silicon layer (244, 288) at the grain boundaries forming a barrier layer to prevent dopant diffusion;
etching the nitridized second oxide layer, wherein etching the nitridized second oxide layer exposes the nitride at a grain boundaries of the second silicon layer (244, 288); and
forming a silicide layer (256, 296) over the second silicon layer (244, 288).

2. A method according to claim 1 wherein:
forming the first oxide layer over the first silicon layer includes growing the first oxide layer at a first process temperature in the range of 900 degrees Centigrade to 1000 degrees Centigrade; and
nitridizing the oxide layer includes nitiridizing the oxide layer at a second process temperature in the range of 900 degrees Centigrade to 1100 degrees Centigrade.

3. A method according to claims 1 or 2, wherein the barrier film has a thickness in the range of 50nm (50 Angströms) to 8 nm (80 Angströms).

4. A method according to any one of the preceding claims, wherein the first silicon layer is doped using a dopant selected from the group consisting of boron, phosphorous, and arsenic.

## Patentansprüche

1. Verfahren zur Minimierung der Dotierstoffausdiffusion in einem integrierten Schaltkreis, wobei das Verfahren Folgendes umfasst:
Bilden eines Substrates (236, 272),
Bilden einer Gatteroxidschicht (238, 276), mindestens teilweise, auf dem Substrat (236, 272),
Aufbringen einer ersten dotierten Silikonschicht (240, 280) auf die Gatteroxidschicht (238, 276),
Bilden einer ersten Oxidschicht auf der ersten Silikonschicht (240, 280),
Nitridieren der ersten Oxidschicht, wobei das Nitridieren der ersten Oxidschicht bewirkt, dass sich mindestens an der Oberfläche der ersten Silikonschicht (240, 280) an den Korngrenzen Nitrid bildet, das eine Sperrschicht bildet, um Dotierstoffdiffusion zu verhindern,
Ätzen der nitridierten ersten Oxidschicht, wobei das Ätzen der nitridierten ersten Oxidschicht das Nitrid an Korngrenzen der ersten Silikonschicht (240, 280) freilegt,
Aufbringen einer zweiten Silikonschicht (244, 288) auf das Nitrid, das an den Korngrenzen der ersten Silikonschicht (240, 280) freigelegt ist,
Bilden einer zweiten Oxidschicht auf der zweiten Silikonschicht (244, 288),
Nitridieren der zweiten Oxidschicht, wobei das Nitridieren der zweiten Oxidschicht bewirkt, dass sich mindestens an der Oberfläche der zweiten Silikonschicht (244, 288) an den Korngrenzen Nitrid bildet, das eine Sperrschicht bildet, um Dotierstoffdiffusion zu verhindern,
Ätzen der nitridierten zweiten Oxidschicht, wobei das Ätzen der nitridierten zweiten Oxidschicht das Nitrid an Korngrenzen der zweiten Silikonschicht (244, 288) freilegt, und
Bilden einer Silizidschicht (256, 296) auf der zweiten Silikonschicht (244, 288).

2. Verfahren gemäß Anspruch 1, wobei:
das Bilden der ersten Oxidschicht auf der ersten Silikonschicht das Heranziehen der ersten Oxidschicht bei einer ersten Prozesstemperatur im Bereich von 900 Grad Celsius bis 1000 Grad Zentigrad umfasst; und
das Nitridieren der Oxidschicht das Nitridieren der Oxidschicht bei einer zweiten Prozesstemperatur im Bereich von 900 Grad Celsius bis 1100 Grad Celsius umfasst.

3. Verfahren nach Anspruch 1 oder 2, wobei der Sperrfilm eine Dicke im Bereich von 5 nm (50 Angström) bis 8 nm (80 Angström) aufweist.

4. Verfahren nach einem der vorhergehenden Ansprüche, wobei die erste Silikonschicht mit einem Dotierstoff dotiert ist, der aus der Gruppe ausgewählt ist, die aus Bor, Phosphor und Arsen besteht.

## Revendications

1. Procédé pour minimiser la sortie par diffusion de dopants à l'intérieur d'un circuit intégré, le procédé comprenant les étapes consistant à :
former un substrat (236, 272) ;
former une couche (238, 276) d'oxyde de grille au moins partiellement au-dessus du substrat (236, 272) ;
déposer une première couche (240, 280) de silicium dopée au-dessus de la couche (238, 276) d'oxyde de grille ;
former une première couche d'oxyde au-dessus de la première couche (240, 280) de silicium ;
nitrurer la première couche d'oxyde, la nitruration de la première couche d'oxyde engendrant la formation de nitrure au moins sur la surface de la première couche (240, 280) de silicium aux joints des grains formant une couche d'arrêt pour empêcher la diffusion de dopants ;
attaquer chimiquement la première couche d'oxyde nitrurée, l'attaque chimique de la première couche d'oxyde nitrurée exposant le nitrure aux joints des grains de la première couche (240, 280) de silicium ;
déposer une deuxième couche (244, 288) de silicium au-dessus du nitrure exposé aux joints des grains de la première couche (240, 280) de silicium ;
former une deuxième couche d'oxyde au-dessus de la deuxième couche (244, 288) de silicium ;
nitrurer la deuxième couche d'oxyde, la nitruration de la deuxième couche d'oxyde engendrant la formation de nitrure au moins sur la surface de la deuxième couche (244, 288) de silicium, aux joints des grains formant une couche d'arrêt pour empêcher la diffusion de dopants ;
attaquer chimiquement la deuxième couche d'oxyde nitrurée, l'attaque chimique de la deuxième couche d'oxyde nitrurée exposant le nitrure aux joints des grains de la deuxième couche (244, 288) de silicium ; et
former une couche (256, 296) de siliciure au-dessus de la deuxième couche (244, 288) de silicium.

2. Procédé selon la revendication 1, dans lequel :
la formation de la première couche d'oxyde au-dessus de la première couche de silicium comprend le fait de faire croître la première couche d'oxyde à une première température de processus, comprise dans la plage de 900 degrés Celsius à 1000 degrés Celsius ; et
la nitruration de la couche d'oxyde comprend le fait de nitrurer la couche d'oxyde à une deuxième température de processus, comprise dans la plage de 900 degrés Celsius à 1100 degrés Celsius.

3. Procédé selon la revendication 1 ou 2, dans lequel le film d'arrêt a une épaisseur comprise dans la plage de 50 mm (50 angströms) à 8 mm (80 angströms).

4. Procédé selon l'une quelconque des revendications précédentes, dans lequel la première couche de silicium est dopée à l'aide d'un dopant sélectionné parmi le groupe composé de bore, de phosphore et d'arsenic.
